# EUROPEAN PATENT SPECIFICATION

(11) **EP 0 650 806 B1**
(45) Date of publication and mention of the grant of the patent: **03.09.1997**
(21) Application number: 94117099.5
(22) Date of filing: 28.10.1994
(51) Int. Cl.: B24B 37/04

(54) **Polishing apparatus of semiconductor wafer**
Poliervorrichtung für Halbleiterscheibe
Dispositif de polissage pour plaquette semi-conductrice

(30) Priority: 28.10.1993 JP 270654/93
(43) Date of publication of application: 03.05.1995
(73) Proprietor: KABUSHIKI KAISHA TOSHIBA, Kawasaki-shi, Kanagawa-ken 210 (JP)
(72) Inventor: Ohashi, Hiroyuki, c/o Intellectual Property Div., Minato-ku, Tokyo 105 (JP); Miyashita, Naoto, c/o Intellectual Property Div., Minato-ku, Tokyo 105 (JP); Katakabe, Ichiro, c/o Intellectual Property Div., Minato-ku, Tokyo 105 (JP); Tsukihara, Tetsuya, c/o Intellectual Property Div., Minato-ku, Tokyo 105 (JP)
(74) Representative: Lehn, Werner, Dipl.-Ing.

(56) References cited:
- FR-A- 2 551 382
- FR-A- 2 626 208
- GB-A- 2 072 550
- PATENT ABSTRACTS OF JAPAN vol. 9, no. 223 (M-411) (1946) 10 September 1985 & JP-A-60 080 560 (TOPPAN INSATU K.K.)
- PATENT ABSTRACTS OF JAPAN vol. 9, no. 311 (M-436) (2034) 7 December 1985 & JP-A-60 146 675 (CANON K.K.)
- PATENT ABSTRACTS OF JAPAN vol. 14, no. 557 (E-1011) 11 December 1990 & JP-A-02 240 925 (HITACHI LTD.)

## Description

The present invention relates to a semiconductor manufacturing device and more particularly to a polishing apparatus for polishing a semiconductor substrate to be flattened.

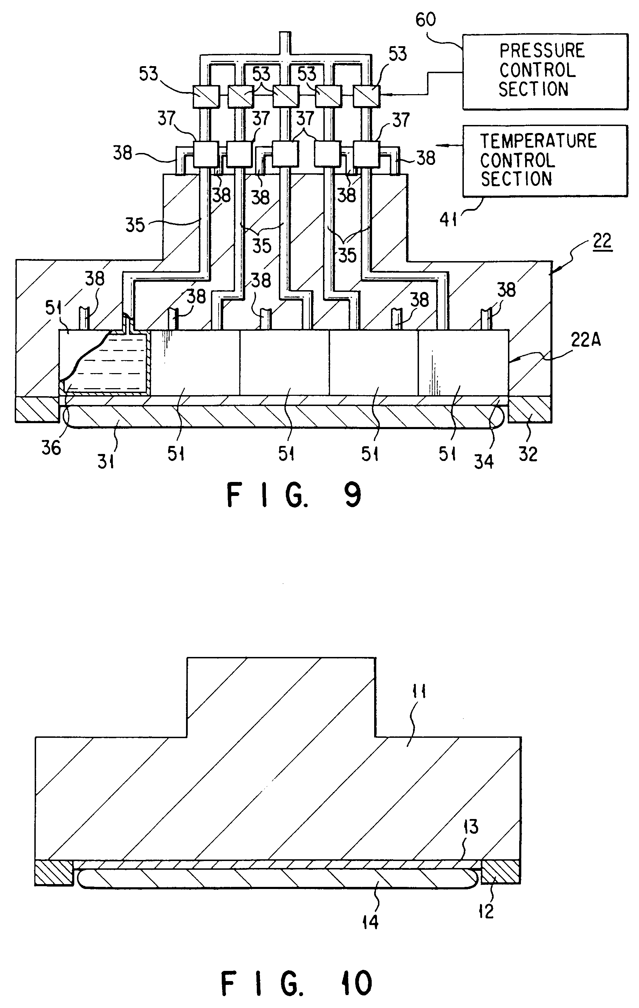

FIG. 10 shows a conventional polishing apparatus. A guide ring 12 is provided around the back face of a top plate 11, and an interlayer material 13 is provided on the back face of the top plate 11, which is positioned at the inside of the guide ring 12. The interlayer material 13 is a cloth to which water penetrates, for example. A semiconductor substrate (wafer) 14 is attracted to the back face of the top plate 11 by the interlayer material 13. As a method for absorbing the wafer 14 to the top plate 11, wax or vacuum chuck can be used. In the case where wax is used, wax is applied on the back surface of the top plate 11, whereby the wafer is attracted to the top plate 11. In the case where vacuum chuck is used, a plurality of intake paths are provided. The wafer, which is attracted to the top plate 11, has a diameter larger than the top plate 11, and is mounted on a polishing plate (not shown) having a polishing cloth is provided on its surface. The polishing plate and the top plate 11 are rotated in a fixed direction, and the wafer is polished by polishing material, which is applied on the polishing cloth.

According to the conventional polishing apparatus, it was difficult to control the temperature of the wafer when polishing. In other words, the temperature of the wafer is increased by friction of the polishing cloth on the wafer and a chemical reaction between the wafer and the polishing material. Due to this, each surface temperature of respective portions of the wafer is not constant. Moreover, a plurality of the wafers are mounted on the polishing plate at one time, and polished simultaneously. However, each temperature of the respective wafers, which are simultaneously polished, was not able to set to be constant. The polishing rate (film thickness/minute: nm/min) depends on the temperature at the time of polishing. Due to this, the polishing rate of each surface of the respective portions of the wafer cannot be equalized. Moreover, the polishing rate of each of the wafers, which are simultaneously polished, and the polishing rate of each batch were not able to be equalized.

An object of the present invention is to provide a polishing apparatus, which can equalize a polishing rate of each surface of the respective portion of a semiconductor substrate, and which can equalize a polishing rate of each batch.

In order to attain the above object, according to the first aspect of the present invention, there is provided a polishing apparatus comprising a top plate having a container section on its back face; a plurality of cells provided in the container section of the top plate wherein each cell is filled with liquid, and a semiconductor substrate to be polished is attracted to each cell; a pipe for introducing liquid to each cell; and heating means, provided in the pipe, for heating liquid, wherein the heating means heat liquid of each cell in accordance with a temperature distribution of the semiconductor substrate.

Further, in order to attain the above object, according to the second aspect of the present invention, there is provided a polishing apparatus comprising a top plate having a container section on its back face; a plurality of flexible cells provided in the container section of the top plate wherein each cell is fulled with liquid, and a semiconductor substrate to be polished is attracted to each cell; a pipe for introducing liquid to each cell; and adjusting means, provided in the pipe, for adjusting liquid in accordance with a warp of the semiconductor substrate.

This invention can be more fully understood from the following detailed description when taken in conjunction with the accompanying drawings, in which:
FIG. 1 is a perspective view schematically showing a polishing apparatus;
FIG. 2 is a cross sectional view schematically showing a polishing apparatus of a first embodiment of the present invention;
FIG. 3 is a structural view showing part of FIG. 2;
FIG. 4 is a characteristic view showing the polishing rate of the present invention and that of the conventional device;
FIG. 5 is a cross sectional view schematically showing a polishing apparatus of a second embodiment of the present invention;
FIG. 6 is a characteristic view showing an operation of FIG. 5;
FIG. 7 is a view showing a distribution of an amount of polishing in a case where a wafer is polished by the device of FIG. 5;
FIG. 8 is a view showing a distribution of an amount of polishing in a case where a wafer is polished by a conventional device;
FIG. 9 is a cross sectional view schematically showing a polishing apparatus of a first embodiment of the present invention; and
FIG. 10 is a a cross sectional view schematically showing a conventional polishing apparatus.

Embodiments of the present invention will be explained with reference to the drawings.

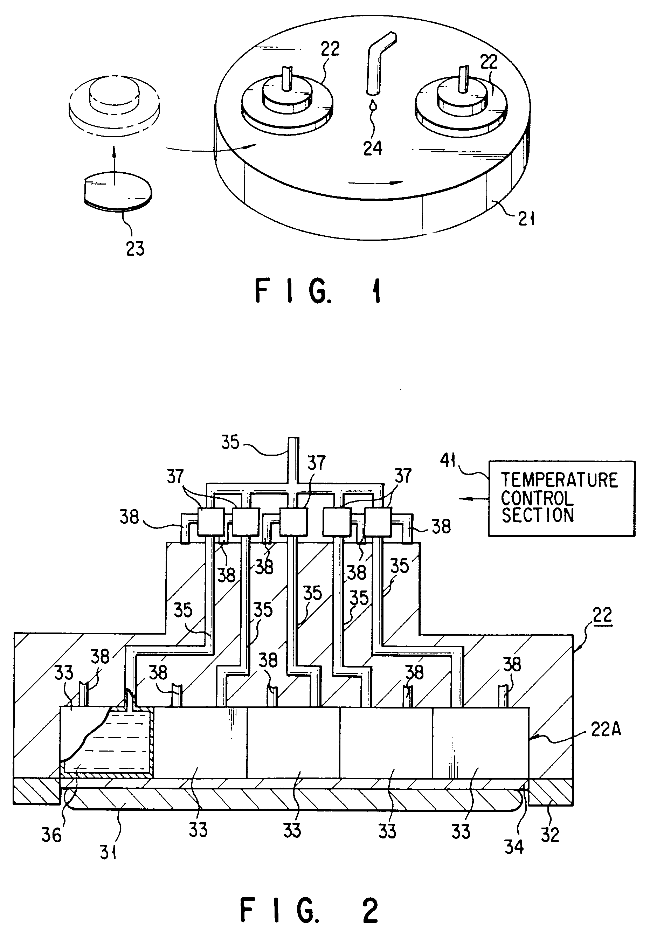

In FIG. 1, a polishing cloth (not shown) is provided on the surface of a polishing plate 21, and a plurality of top plates 22 are mounted on the polishing cloth. The top plate 22 is movable from the surface of the polishing plate 21 as shown in a broken line. A semiconductor substrate (hereinafter called as a wafer) 23 is attracted by the top plate 22 or detached from the top plate 22 at a position shown by the broken line. The polishing plate 21 is rotated in a fixed direction, and the wafer, which is attracted by the top plate 22, is polished by a friction of the polishing cloth and a chemical reaction with polishing material 24 applied onto the polishing cloth.

FIG. 2 shows a first embodiment of the present invention. A circular concave portion 22A, for example, is formed on the back face of the top plate 22. A guide ring 32 for positioning a wafer 31 is provided around the concave portion 22A. A plurality of cells 33 are provided in the concave portion 22A. These cells 33 are formed of nylon having heat resistance or vinyl chloride, rubber. The position of the bottom surface of each cell 33 is substantially conformed to that of the back face of the top plate 22. An interlayer material 34 is provided on the bottom surface of each cell 33, which is positioned at the inside of the guide ring 32. The interlayer material 34 is a cloth to which water, for example, is penetrated, and the wafer 31 is attracted by the interlayer material 34.

On the other hand, a plurality of first pipes 35 are connected to each other at their one ends, and other ends are communicated with the cells 33, respectively. Each of the first pipes 35 is used to introduce liquid, for example, water to each cell 33, and a constant-temperature device 37 is provided at an intermediate section of each first pipe 35. Further, one end of each of a second pipe 38 is connected to each of the first pipe 35, and other end of each of the second pipe 38 is communicated with each of the cells 33. Each of the second pipe 38 is used to discharge liquid 36 from the cell 33, and introduce liquid to the first pipe 35.

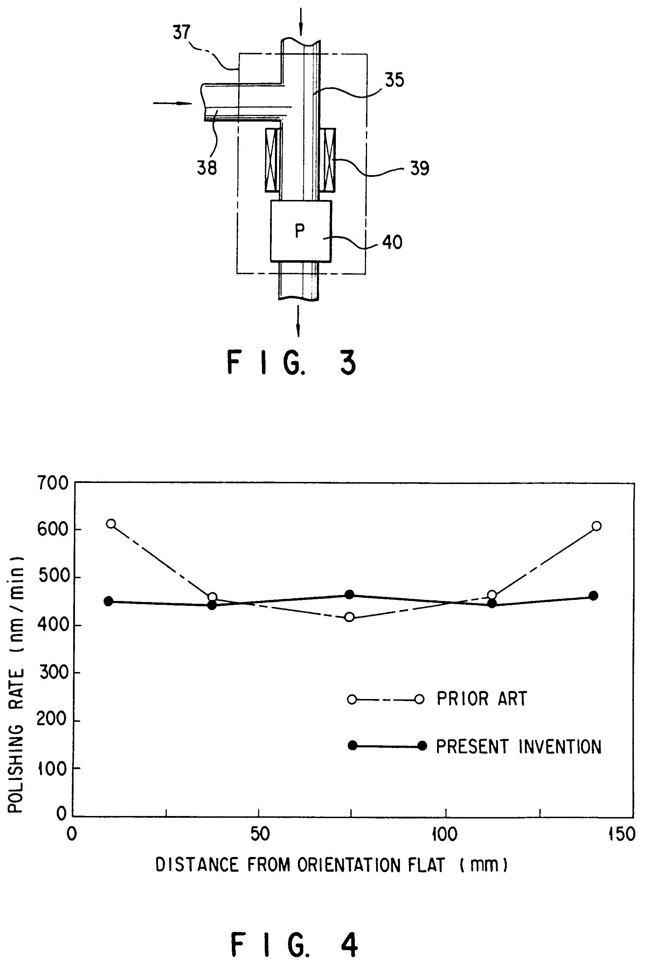

FIG. 3 shows the constant-temperature device 37. A heater 39 is provided around the first pipe 35, which is positioned at a lower portion than a connecting section between the first and second pipes 35 and 38, and liquid 36, which flows into the first pipe 35, is heated by the heater 39. A pump (P) 40 is provided at a lower portion than the heater 39 of the first pipe 35. Liquid 38, which is heated by the heater 39, is circulated through the first pipe 35, the cell 33, and the second pipe 38 in order by the pump 40. Moreover, as shown in FIG. 2, a temperature control section 41 is connected to each constant-temperature device 37. The temperature control section 41 controls the heater 39 of each constant-temperature device 37, individually. Therefore, liquid 36 of each cell 33 is controlled to an arbitrary temperature.

In a case where the wafer is polished by the above-structured top plate 22, the wafer 31 is attracted by the interlayer material 34 of the top plate 22. Liquid 36, which is temperature-controlled by the constant-temperature device 37, is supplied to each cell 33, and the wafer 31 is heated by liquid 36 of each cell 33. Under this state, as shown in FIG. 1, the wafer 31 is mounted on the polishing plate, and polished by the function of the polishing cloth and that of the polishing material. In this case, the temperature distribution of the wafer 31 is changed by the friction of the polishing cloth and the chemical reaction of the polishing material. As mentioned above, the polishing rate depends on the temperature. Therefore, regarding a portion where the temperature of the wafer 31 is low and the polishing rate is low, the temperature of liquid 36 of the cell 33 corresponding to the above portion is increased by the constant-temperature device 37, whereby the polishing rate can be increased. In other words, for example, the distribution of the polishing rate of the wafer is measured in advance, and the temperature of liquid 36 of the cell 33, which corresponds to the portion where the polishing rate is low, is increased by the constant-temperature device 37, whereby the polishing rate of each portion of the wafer can be equalized.

FIG. 4 shows the polishing rate in the case where the device of the first embodiment is used and the polishing rate in the case where the conventional device is used. As is obvious from the figure, in the case of the conventional device, the polishing rate of the peripheral portion of the wafer and that of the central portion are largely different. However, in the case where the device of the present invention is used, the polishing rate of the peripheral portion of the wafer and that of the central portion can be equalized.

According to the first embodiment, the plurality of the cells 33 are provided on the top plate 22, and the temperature of liquid 36 of each cell 33 is controlled, whereby the temperature distribution of the wafer can be adjusted. Therefore, the polishing rate of each part of the wafer can be equalized, and the polishing rate of each batch can be equalized.

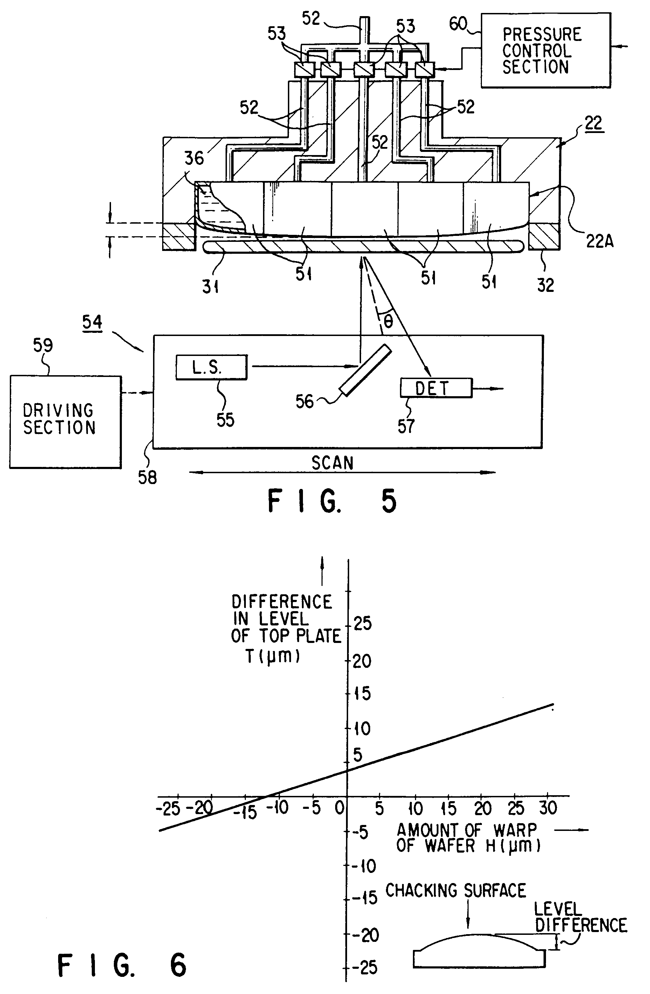

FIG. 5 shows a second embodiment of the present invention, and the same reference numerals as the first embodiment are added to the same portions as the first embodiment.

In FIG. 5, a plurality of cells 51 are provided in the concave portion 22A of the top plate 22. These cells 51 are formed of flexible material such as nylon or rubber. The position of the bottom surface (chucking surface) of each cell 51 is substantially conformed to that of the back face of the top plate 22. Wax (not shown), for example, is applied onto the bottom surface of each cell 51, which is positioned at the inside of the guide ring 32, and the wafer 31 is attracted to the bottom face of each cell 51 through wax. The attracting method of the wafer 31 is not limited to wax, and interlayer material having a cloth to which water is penetrated and a vacuum chuck can be used. In the case where the interlayer material is used, it is needed that material, which can transfer the position and the pressure of the chucking surface of each cell 51 to the wafer 31, be selected as described later. In the case where the vacuum chuck is used, the intake path is provided between the respective cells 51.

On the other hand, a plurality of first pipes 52 are connected to each other at their one ends, and other ends are communicated with the cells 51, respectively. Each of the first pipes 52 is used to introduce liquid 36, for example, water to each cell 51. A valve 53 is provided at an intermediate portion of each pipe 52 so as to control pressure of each cell 51. By the function of the valve 53, pressure to be added to the semiconductor wafer 31 from the cell 51 is changed.

At the lower portion of the top plate 22, there is provided a measuring section 54 for measuring a warp of the wafer 31. The measuring section 54 is provided between the polishing plate 21 shown in FIG. 1 and a top plate shown by a broken line. The measuring section 54 comprises, for example, a housing 58, a light source (L.S) 55, which is provided in the housing 58, for emitting a laser beam, a mirror 56, a detector 57, formed of, for example, a CCD line sensor, for detecting light, and a driving section 59, which moves the housing 58 along the wafer 31, and scans the wafer 31.

The polishing surface of the wafer 31 is irradiated with the laser beam emitted from the light source 55 by the mirror 56. The laser beam reflected on the wafer 31 is made incident onto the detector 57. An angle θ of reflection of the laser beam due to the wafer 31 changes in accordance with the warp of the wafer 31, and the position of the laser beam incident onto the detector 57 changes in accordance with the angle θ of reflection. Therefore, the warp of each part of the wafer 31 can be detected from the incident position of the laser beam onto the detector 57. An output signal of the detector 57 is supplied to a pressure control section 60. The pressure control section 60 controls each valve 53 in accordance with the output signal of the detector 57, and adjusts pressure of each cell 51 in accordance with the warp of the wafer 31. Therefore, the position of the chucking surface of each cell 51 can be adjusted in accordance with the warp of the wafer 31.

FIG. 6 is a characteristic view showing the relationship an amount of warp H of the wafer 31 and a level difference T of the chucking surface of each cell 51. The pressure control section 60 controls the position of the chucking surface of each cell 51 in accordance with the detected amount of the warp based on the characteristic view. In this way, by polishing in a state that the warp of the wafer is corrected, the variation of the polishing rate of each part of the wafer can be controlled, and the polishing rate of each batch can be equalized.

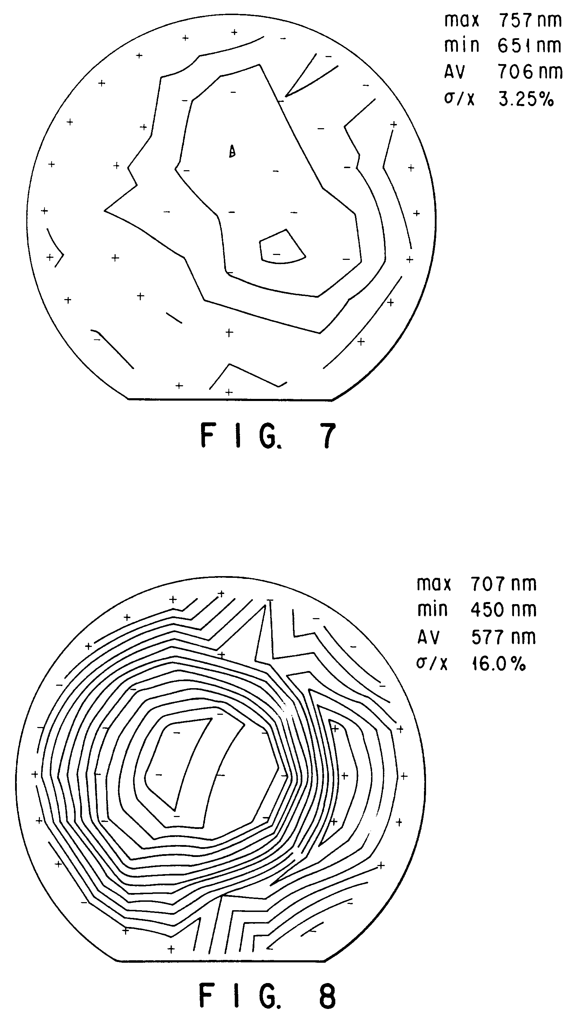

FIGS. 7 and 8 show a map of the amount of polishing of each wafer. FIG. 7 shows a case in which polysilicon of the wafer is polished by the device of the second embodiment, and FIG. 8 shows a case in which polysilicon of the wafer is polished by the conventional device. In the case in which polysilicon of the wafer is polished by the conventional device of, the variation of the inner surface of the polishing rate was about 16%. In the case in which polysilicon of the wafer is polished by the device of the second embodiment, the variation of the surface of the polishing rate was able to reduce to about 3%. Moreover, in the case in which polysilicon of the wafer is polished by the device of the second embodiment, the variation of the polishing rate between the respective wafers was able to reduced to about 3 to 5%.

FIG. 9 shows a third embodiment of the present invention in which the first and second embodiment are combined, and the same reference numerals as the first and second embodiments are added to the same portions as the first and second embodiments. FIG. 9 shows only the top rate, and the measuring section of FIG. 5 is omitted. The valve 53, and the constant-temperature device 37 are provided in the first pipe 35. Each valve 53 is controlled by the pressure control section 60, and each constant-temperature device 37 is controlled by the temperature control section 41. The first pipe 35 and the second pipe 38 are connected to each cell 51. Liquid 36 of each cell 51 is heated by the constant-temperature device 37 in a state that a predetermined pressure is applied by the valve 53. Then, liquid 36 is circulated in the first pipe 35, the cell 51, and the second pipe 38.

According to the third embodiment, the temperature of liquid 36 of each cell 51 and the pressure are controlled in accordance with the temperature of each part of the wafer, and the amount of the warp. Therefore, the polishing rate can be adjusted in accordance with the temperature of each part of the wafer, and the amount of the warp, the polishing rate of the inner surface of the wafer can be further equalized.

## Claims

1. A polishing apparatus comprising:
a top plate (22) having a concave portion (22A) on its back face; characterized by:
a plurality of cells (33) provided in the concave portion of said top plate, wherein each of said cells is filled with liquid (36) and a semiconductor substrate (31) to be polished is attracted to each cell;
a pipe (35, 38) for introducing said liquid (36) to each of said cells (33); and
adjusting means (37), provided in said pipe (35, 38), for adjusting a temperature of said liquid (36), wherein said adjusting means (37) adjusts the temperature of liquid of each cell in accordance with a temperature distribution of said semiconductor substrate (31).

2. The apparatus according to claim 1, characterized in that said pipe comprises:
a first pipe (35) for introducing said liquid to each of said cells; and
a second pipe (35) having one end connected to each of said cells and other end connected to said first pipe for discharging said liquid from said cell, and introducing said liquid to the first pipe.

3. The apparatus according to claim 1, characterized in that said adjusting means comprises;
a heater (39), provided around said first pipe, for heating liquid of said first pipe; and
a pump (40), provided in said first pipe, for moving liquid of said first pipe.

4. A polishing apparatus comprising:
a top plate (22) having a concave portion (22A) on its back face; characterized by:
a plurality of flexible cells (51) provided in the concave portion of said top plate, wherein each of said cells (51)is filled with liquid (36) and a semiconductor substrate (31) to be polished is attracted to each cell;
a pipe (52) for introducing said liquid to each of said cells (51); and
adjusting means (53), provided in said pipe (52), for adjusting pressure of said liquid, wherein said adjusting means (53) adjusts a position of a surface where the semiconductor substrate (31) of said cell is attracted in accordance with an amount of warp of said semiconductor substrate (31).

5. The polishing apparatus according to claim 4, characterized by further comprising:
measuring means (54) for irradiating said semiconductor substrate (31) with light, and measuring an amount of a warp of said semiconductor substrate in accordance with an angle of light reflected on said semiconductor substrate; and
controlling means (60) for controlling said adjusting means (53) in accordance with the amount of the warp of said semiconductor substrate measured by said measuring means (54).

6. The apparatus according to claim 5, characterized in that said measuring means (54) comprising:
a housing (58);
driving means (59) for driving said housing (58) along said semiconductor substrate (31);
a light source (55), provided in said housing (58), for generating a laser beam;
means (56) for guiding the laser beam generated by said light source (55) to said semiconductor substrate (31); and
detecting means (57) for detecting the laser beam reflected on said semiconductor substrate (31), wherein said detecting means (57) detects the amount of the warp of the semiconductor substrate by the detected angle of reflection of the laser beam

7. The apparatus according to claim 5, characterized in that said adjusting means comprises a valve (53).

## Patentansprüche

1. Poliervorrichtung, umfassend:
eine obere Platte (22) mit einem konkaven Abschnitt (22A) auf ihrer Rückseite;
**gekennzeichnet durch:**
eine Vielzahl von Zellen (33), die in dem konkaven Abschnitt der oberen Platte vorgesehen sind, wobei jede Zelle mit Flüssigkeit (36) gefüllt ist und ein zu polierendes Halbleitersubstrat an jede Zelle angezogen wird;
ein Rohr (35, 38) zum Einleiten der Flüssigkeit (36) in jede der Zellen (33); und
eine Einstelleinrichtung (37), die in dem Rohr (35, 38) vorgesehen ist, zum Einstellen einer Temperatur der Flüssigkeit (36), wobei die Einstelleinrichtung (37) die Temperatur der Flüssigkeit jeder Zelle gemäß einer Temperaturverteilung des Halbleitersubstrats (31) einstellt.

2. Vorrichtung nach Anspruch 1,
**dadurch gekennzeichnet, daß** das Rohr umfaßt:
ein erstes Rohr (35) zum Einleiten der Flüssigkeit in jede der Zellen; und
ein zweites Rohr (35) mit einem Ende, welches mit jeder der Zellen verbunden ist, und mit einem anderen Ende, das mit dem ersten Rohr zum Abgeben der Flüssigkeit von der Zelle verbunden ist, und zum Einleiten der Flüssigkeit an das erste Rohr.

3. Vorrichtung nach Anspruch 1,
**dadurch gekennzeichnet, daß** die Einstelleinrichtung umfaßt:
einen Erwärmer (39), der um das erste Rohr herum vorgesehen ist, zum Erwärmen von Flüssigkeit des ersten Rohrs;
eine Pumpe (40), die in dem ersten Rohr vorgesehen ist, zum Bewegen von Flüssigkeit des ersten Rohrs.

4. Poliervorrichtung, umfassend:
eine obere Platte (22) mit einem konkaven Abschnitt (22A) auf ihrer Rückseite;
**gekennzeichnet durch:**
eine Vielzahl von flexiblen Zellen (51), die in dem konkaven Abschnitt der oberen Platte vorgesehen sind, wobei jede der Zellen (51) mit Flüssigkeit (36) gefüllt ist und ein zu polierendes Halbleitersubstrat (31) an jede Zelle angezogen wird;
ein Rohr (52) zum Einleiten der Flüssigkeit an jede der Zellen (51); und
eine Einstelleinrichtung (53), die in dem Rohr (52) vorgesehen ist, zum Einstellen eines Drucks der Flüssigkeit, wobei die Einstelleinrichtung (53) eine Position einer Oberfläche, an die das Halbleitersubstrat (31) der Zelle angezogen wird, gemäß einem Wölbungsbetrag des Halbleitersubstrats (31) einstellt.

5. Poliervorrichtung nach Anspruch 4,
**dadurch gekennzeichnet, daß** sie ferner umfaßt:
eine Meßeinrichtung (54) zum Bestrahlen des Halbleitersubstrats (31) mit Licht und zum Messen eines Wölbungsbetrags des Halbleitersubstrats gemäß einem Winkel eines Lichts, welches von dem Halbleitersubstrat reflektiert wird; und
eine Steuereinrichtung (60) zum Steuern der Einstelleinrichtung (53) gemäß dem Wölbungsbetrag des Halbleitersubstrats, der von der Meßeinrichtung (54) gemessen wird.

6. Vorrichtung nach Anspruch 5,
**dadurch gekennzeichnet, daß** die Meßeinrichtung (54) umfaßt:
ein Gehäuse (58);
eine Antriebseinrichtung (59), um das Gehäuse (58) entlang des Halbleitersubstrats (31) zu bewegen;
eine Lichtquelle (55) die in dem Gehäuse (58) vorgesehen ist, zum Erzeugen eines Laserstrahls;
eine Einrichtung (56) zum Führen des von der Lichtquelle (55) erzeugten Laserstrahls auf das Halbleitersubstrat (31); und
eine Erfassungseinrichtung (57) zum Erfassen des auf dem Halbleitersubstrat (31) reflektierten Laserstrahls, wobei die Erfassungseinrichtung (57) den Wölbungsbetrag des Halbleitersubstrats durch den erfaßten Reflektionswinkel des Laserstrahls erfaßt.

7. Vorrichtung nach Anspruch 5,
**dadurch gekennzeichnet, daß** die Einstelleinrichtung ein Ventil (53) umfaßt.

## Revendications

1. Appareil de polissage, comprenant :
une plaque supérieure (22) ayant une partie concave (22A) à sa face arrière, caractérisé par
plusieurs cellules (33) placées dans la partie concave de la plaque supérieure, chacune des cellules étant remplie d'un liquide (36), et un substrat semi-conducteur (31) à polir est attiré vers chaque cellule,
un conduit (35, 38) d'introduction du liquide (36) dans chacune des cellules (33), et
un dispositif (37) d'ajustement placé dans le conduit (35, 38) et destiné à ajuster la température du liquide (36), le dispositif d'ajustement (37) ajustant la température du liquide de chaque cellule en fonction de la distribution de température du substrat semi-conducteur (31).

2. Appareil selon la revendication 1, caractérisé en ce que le conduit comprend :
un premier conduit (35) d'introduction du liquide dans chacune des cellules, et
un second conduit (35) ayant une première extrémité raccordée à chacune des cellules et une autre extrémité raccordée au premier conduit pour l'évacuation du liquide de la cellule, et l'introduction du liquide dans le premier conduit.

3. Appareil selon la revendication 1, caractérisé en ce que le dispositif d'ajustement comprend :
un organe de chauffage (39) placé autour du premier conduit et destiné à chauffer le liquide du premier conduit, et
une pompe (40) placée dans le premier conduit et destinée à déplacer le liquide du premier conduit.

4. Appareil de polissage comprenant :
une plaque supérieure (22) ayant une partie concave (22A) à sa face arrière, caractérisé par
plusieurs cellules flexibles (51) placées dans la partie concave de la plaque supérieure, chaque cellule (51) étant remplie d'un liquide (36), et un substrat semi-conducteur (31) à polir est attiré vers chaque cellule,
un conduit (52) destiné à introduire le liquide dans chacune des cellules (51), et
un dispositif (53) d'ajustement placé dans le conduit (52) et destiné à ajuster la pression du liquide, le dispositif d'ajustement (53) ajustant la position d'une surface dans laquelle le substrat semi-conducteur (31) de la cellule est attiré en fonction de l'amplitude de gauchissement du substrat semi-conducteur (31).

5. Appareil de polissage selon la revendication 4, caractérisé en ce qu'il comprend en outre :
un dispositif (54) de mesure destiné à irradier le substrat semi-conducteur (31) de lumière et à mesurer l'amplitude du gauchissement du substrat semi-conducteur en fonction de l'angle de la lumière réfléchie sur le substrat semi-conducteur, et
un dispositif (60) de commande du dispositif d'ajustement (53) d'après l'amplitude du gauchissement du substrat semi-conducteur mesurée par le dispositif de mesure (54).

6. Appareil selon la revendication 5, caractérisé en ce que le dispositif de mesure (54) comprend :
un boîtier (58),
un dispositif (59) d'entraînement du boîtier (58) le long du substrat semi-conducteur (31),
une source lumineuse (55) placée dans le boîtier (58) et destinée à créer un faisceau laser,
un dispositif (56) de guidage du faisceau laser créé par la source lumineuse (55) vers le substrat semi-conducteur (31), et
un dispositif (57) de détection du faisceau laser réfléchi par le substrat semi-conducteur (31), le dispositif (57) détectant l'amplitude du gauchissement du substrat semi-conducteur d'après l'angle détecté de réflexion du faisceau laser.

7. Appareil selon la revendication 5, caractérisé en ce que le dispositif d'ajustement comporte une soupape (53).
